# EUROPEAN PATENT SPECIFICATION

(11) **EP 3 437 117 B1**
(45) Date of publication and mention of the grant of the patent: **21.09.2022**
(21) Application number: 16896658.8
(22) Date of filing: 29.03.2016
(51) Int. Cl.: C23C 16/26, C23C 16/34, H01J 35/18, H01J 5/18, G01T 1/00

(54) **RADIATION WINDOW STRUCTURE AND A METHOD FOR MANUFACTURING THE RADIATION WINDOW STRUCTURE**
STRAHLUNGSFENSTERSTRUKTUR UND VERFAHREN ZUR HERSTELLUNG DER STRAHLUNGSFENSTERSTRUKTUR
STRUCTURE DE FENÊTRE DE RAYONNEMENT ET PROCÉDÉ DE FABRICATION DE LA STRUCTURE DE FENÊTRE DE RAYONNEMENT

(43) Date of publication of application: 06.02.2019
(73) Proprietor: AMETEK Finland Oy, 02150 Espoo (FI)
(72) Inventor: SIPILÄ, Heikki Johannes, 02270 Espoo (FI)
(74) Representative: Berggren Oy
(86) International application number: PCT/FI2016/050193
(87) International publication number: WO 2017/168033

(56) References cited:
- WO-A1-2004/097882
- WO-A1-2013/121078
- US-A1- 2009 095 917
- US-A1- 2011 311 029
- US-A1- 2014 008 538

## Description

### TECHNICAL FIELD

The invention concerns in general the technical field of radiation applications. Especially the invention concerns radiation windows.

### BACKGROUND

A radiation window is a part of a measurement apparatus that allows a desired part of electromagnetic radiation to pass through. In many cases the radiation window must nevertheless be gastight, in order to seal and protect an enclosure where reduced pressure and/or a particular gas contents prevail. In order to cause as little absorption as possible of the desired radiation, a major part of the radiation window should consist of a thin foil with dimensions applicable in the application area.

Beryllium is known as a very good material for radiation window foils especially in X-ray measurement apparata, because it has a low atomic number (4) and consequently exhibits very low absorption of X-rays. Another characteristic of beryllium that makes it very useful for radiation window foils is its exceptional flexural rigidity. The thinnest beryllium foils that are commercially available for use in radiation windows at the time of writing this description have a thickness in the order of 8 micrometres. According to prior art, the beryllium foil is manufactured from an ingot by rolling. Various coatings can be applied to the beryllium foil for example to enhance its gastightness and corrosion resistance as well as to keep undesired parts of the electromagnetic spectrum (such as visible light) from passing through the foil. An example of known radiation window foils is the DuraBeryllium foil available from Moxtek Inc., Orem, UT, USA. It comprises an 8 micrometres thick beryllium foil coated with a DuraCoat coating. DuraBeryllium, DuraCoat, and Moxtek are registered trademarks of Moxtek Incorporated.

At the time of writing this description it appears that the rolling technology has met its limits in the sense that it has not been shown capable of manufacturing beryllium foils thinner than 8 micrometres so that they would still be sufficiently gastight. This phenomenon is associated with the relatively large grain size (larger than foil thickness), which results from the grain structure of the original beryllium ingot. Grain boundaries in the beryllium foil tend to cause gas leaks through the foil. Additionally beryllium has disadvantages as a material because it is toxic. This brings additional requirements for the manufacturing process. Also, the future in the utilization of beryllium is uncertain due to tightening requirements by different national authorities.

However, if the radiation window is very thin, the mechanical stress on different sides of the radiation window may break the thin radiation window.

Thus, there is a need to mitigate the aforementioned problems and develop a solution for providing a thin and gastight radiation window.

A patent application WO 2004/097882 A1 discloses a membrane which is substantially transparent for particle beams or electromagnetic radiation, which is made from materials whose chemical elements primarily have a small atomic number, which is able to withstand pressure differences greater than 1 mbar, and which comprises at least one layer having a high emissivity of electromagnetic radiation.

A patent application WO 2013/121078 A1 discloses a method for manufacturing a radiation window, where there is produced a layered structure where an etch stop layer exists between a carrier and a solid layer. A blank containing at least a part of each of said carrier, said etch stop layer, and said solid layer is attached to a radiation window frame. At least a part of what of said carrier was contained in said blank is removed, thus leaving a foil attached to said radiation window frame, wherein said foil contains at least a part of each of said etch stop layer and said solid layer.

A patent application US 2011/311029 A1 discloses a radiation window membrane and a method for its manufacturing. Said openings are such through which X-rays are to pass. The membrane comprises a window base layer and a pinhole-blocking layer on a surface of said window base layer. Said pinhole-blocking layer comprises graphene.

### SUMMARY

An objective of the invention is to present a method for manufacturing a radiation window structure. Another objective of the invention is that the method for manufacturing a radiation window structure provides a gastight radiation window structure.

The objectives of the invention are reached by a method as defined by the respective independent claim.

According to a first aspect, a method for manufacturing a radiation window structure is provided, the method comprising growing a coating layer from a vapor phase on all outer surfaces of a substrate made of silicon nitride simultaneously.

The coating layer grown from the vapor phase may be made of pyrolytic carbon.

The said growing may comprise pyrolysis.

The gas used in said growing the coating layer from the vapor phase may be methane.

Alternatively or in addition, the method may comprise producing a mesh layer between the substrate and the coating layer at least on one surface of the substrate.

Alternatively or in addition, the method may comprise producing a silicon nitride layer between the mesh layer on at least one surface of the substrate and the coating layer.

The exemplary embodiments of the invention presented in this patent application are not to be interpreted to pose limitations to the applicability of the appended claims. The verb "to comprise" is used in this patent application as an open limitation that does not exclude the existence of also un-recited features. The features recited in depending claims are mutually freely combinable unless otherwise explicitly stated.

The novel features which are considered as characteristic of the invention are set forth in particular in the appended claims. The invention itself, however, both as to its construction and its method of operation, together with additional objectives and advantages thereof, will be best understood from the following description of specific embodiments when read in connection with the accompanying drawings.

### BRIEF DESCRIPTION OF FIGURES

The embodiments of the invention are illustrated by way of example, and not by way of limitation, in the figures of the accompanying drawings.
Figure 1 illustrates a method and a radiation window according to an embodiment of the invention.
Figure 2 illustrates a method and a radiation window according to another embodiment of the invention.
Figure 3 illustrates a method and a radiation window according to yet another embodiment of the invention.
Figure 4 illustrates a method and a radiation window according to yet another embodiment of the invention.

### DESCRIPTION OF SOME EMBODIMENTS

In this description we use the following vocabulary. A layer means a quantity of essentially homogeneous material that by its form has much larger dimensions in two mutually orthogonal directions than in the third orthogonal direction. In most cases of interest to the present invention, the dimension of a layer in said third orthogonal direction (also referred to as the thickness of the layer) should be constant, meaning that the layer has uniform thickness. A foil is a structure, the form of which may be characterised in the same way as that of a layer (i.e. much larger dimensions in two mutually orthogonal directions than in the third orthogonal direction) but which is not necessarily homogeneous: for example, a foil may consist of two or more layers placed and/or attached together. A mesh is a special case of a layer or foil, in which the constituents do not make up a continuous piece of material but define an array of (typically regular, and regularly spaced) openings. A radiation window foil is a foil that has suitable characteristics (such as low absorption, sufficient gas tightness, sufficient mechanical strength etc.) for use in a radiation window of a measurement apparatus. A radiation window is an entity that may comprise a piece of radiation window foil attached to a (typically annular) support structure so that electromagnetic radiation may pass through an opening defined by the support structure without having to penetrate anything else than said piece of radiation window foil and the (typically gaseous) medium that otherwise exists within said opening. In this application a term radiation window structure corresponds to the term radiation window foil.

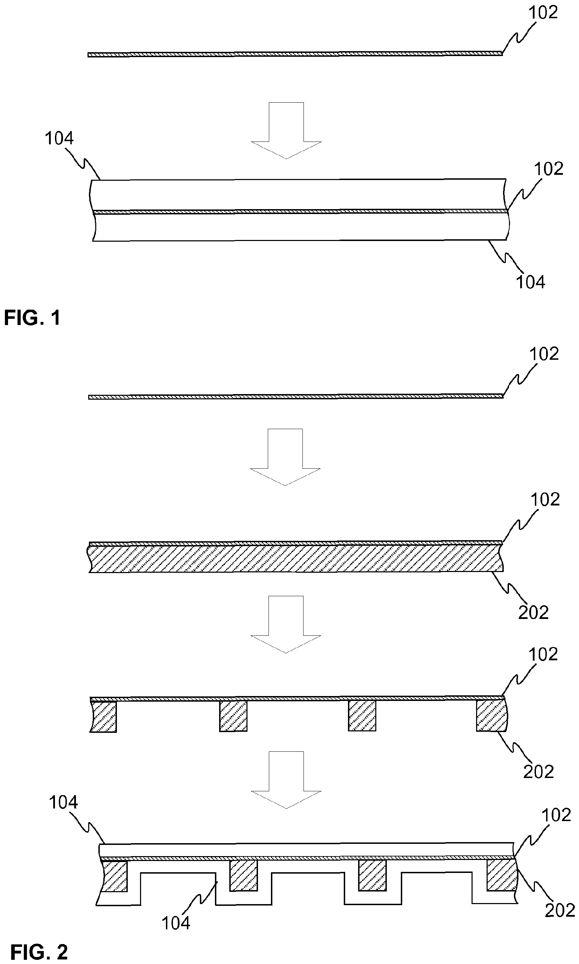

Fig. 1 illustrates a workpiece in various steps of a method for manufacturing a radiation window structure according to an embodiment of the invention. The topmost step illustrates a substrate 102 made of silicon nitride. The substrate 102 may be provided in a silicon frame in order to ease the handling of the radiation window structure. The substrate 102 may be between 5 and 500 nanometers thick. Preferably, the substrate 102 is between 40 to 50 nanometers thick. If the substrate 102 was thinner, its mechanical strength would be so low that the need for additional support solutions could be required. If the substrate 102 was thicker, its absorption might come too high concerning very sensitive X-ray fluorescence measurements, like the detection of sodium. The use of a substrate 102 made of silicon nitride enables manufacturing a thin and gastight radiation window.

In the next step of the method illustrated in Fig. 1 a coating layer 104 is grown from a vapor phase on outer surface of the substrate 102. In the other words the substrate 102 is coated with the coating layer 104. The gas may be methane, for example. The coating layer 104 may be grown on the whole surface of the substrate 102 simultaneously and at the same speed. In other words all the outer surfaces of the substrate 102 are coated with the coating layer 104 simultaneously. By growing the coating layer 104 simultaneously and at the same speed on the whole surface of the substrate 102, as illustrated in Fig. 1, deformation of the coating layer 104 and/or defects in the coating layer 104 may be at least partly reduced. Thus, also the quality of the coating layer 104 may be improved at least partly. The material for the coating layer 104 may preferably be selected so that the thermal expansion coefficient of the coating layer 104 material is close to the thermal expansion coefficient of the substrate 102 material. The thermal expansion coefficient of the silicon nitride is 3.27·10⁻⁶ °C⁻¹. Preferably, the thermal expansion coefficient of the coating layer 104 material may differ from the thermal expansion coefficient of the silicon nitride less than 3·10⁻⁶ °C⁻¹. The coating layer 104 may be made of pyrolytic carbon. The thermal expansion coefficient of the pyrolytic carbon is 0.5·10⁻⁶ °C⁻¹. The use of pyrolytic carbon in the coating layer 104 is preferable, because of at least the following reasons: the pyrolytic carbon is not toxic, the atomic number of the pyrolytic carbon is small, helium leakage through the pyrolytic carbon is low. However, the substrate made of silicon nitride is a good diffusion barrier that assures that the radiation window is gastight. The thickness of the coating layer 104 may be between 20 nanometers and 5 micrometers. If the coating layer 104 was thinner, the manufacturing of the coating layer might become unreliable and more challenging. If the coating layer 104 was thicker, its absorption might come too high. Preferably, the coating layer 104 may be between 300 and 500 nanometers.

Pyrolysis may be used to grow the coating layer 104 from a vapor phase. Pyrolysis is a reaction used to coat a preformed substrate with a layer of pyrolytic carbon. Pyrolysis occurs at high temperature, such as 1000 to 2000 degrees Celsius. The gas used in pyrolysis may be methane, for example.

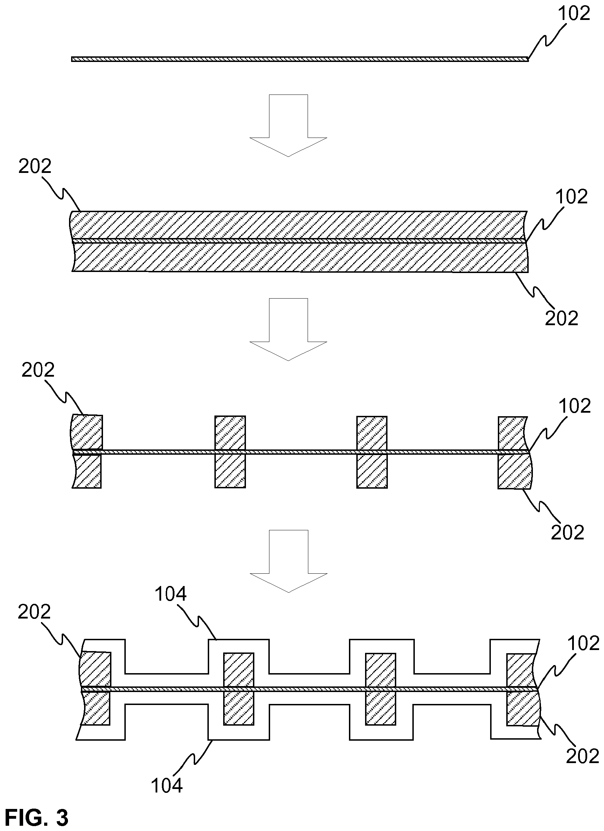

Figure 2 illustrates part of a radiation window manufacturing method according to yet another embodiment of the invention. The first step is comparable to corresponding step in Figure 1 earlier. Thus, the topmost step illustrates a substrate 102 made of silicon nitride. At the second step of Figure 2 a mesh layer 202 is produced on at least on one surface of the substrate 102. In Figure 2 the mesh layer 202 is produced on the second surface of the substrate 102. Alternatively or in addition, the mesh layer 202 may be produced on the first surface of the substrate 102. Figure 3 illustrates part of a radiation window manufacturing method according to yet another embodiment of the invention, wherein the mesh layer 202 is produced on the first surface of the substrate 102 and on the second surface of the substrate 102. Otherwise, the steps in Figure 3 are comparable to corresponding steps in Figure 2. The mesh layer 202 may be manufactured using a thin film deposition technique. Suitable methods for depositing the mesh layer 202 include, but are not limited to, chemical vapour deposition and pulsed laser deposition. At first, the mesh layer 202 is uniform. The mesh layer 202 may be made of silicon, for example. The criteria to be applied in choosing the material for the mesh layer 202 include reasonable mechanical strength, good binding to the substrate 102, suitability to etching with an etching method and/or agent that does not affect the substrate 102 to a significant extent, low absorption of radiation, absence of disturbing fluorescence peaks and/or other awkwardly handled anomalities at the wavelengths of electromagnetic radiation at which the radiation window is to be used, as well as easy handling in a thin film deposition process. Preferably, the mesh layer 202 may be between 20 nanometers and 500 micrometers thick.

In the third step in Figure 2, regularly spaced portions of the originally uniform mesh layer 202 are removed to turn said uniform layer into a mesh. In Figure 2 regularly spaced mesh is used as an example, but also irregular mesh may be used. The characteristic dimensions of the mesh may include for example a diameter of openings in the order of 1 to 5000 micrometres, and a width of the ribs in the mesh in the order of 50 to 5000 micrometres. Assuming that the process of turning the originally uniform layer into a mesh does not significantly affect those parts of the layer that are to form the ribs, the height (the dimension in the vertical direction in Figure 2) of the ribs constituting the mesh will be essentially the same as the original thickness of the uniform layer. These dimensions are examples only, and the eventual selection of characteristic dimensions should be made in accordance with the mechanical strength that the completed radiation window should have. Several methods for turning a previously uniform, thin-film-deposited layer into a mesh layer are known, including but not being limited to photolithography, wet etching, dry etching, plasma etching, electron beam lithography, and ion beam lithography. The method should naturally be selected so that it still leaves the window continuous. The mesh layer 202 may be used to improve the mechanical strength of the window structure.

At the last step in Figure 2, a coating layer 104 is grown from a vapor phase on outer surface of the combined structure comprising substrate 102 and at least one mesh layer 202 as described above. Thus, the mesh layer 202 is provided between the substrate 102 and the coating layer 104 at least on one surface of the substrate 102. The last step in Figure 2 is comparable to corresponding last step in Figure 1 earlier. The mesh layer 202 between the substrate 102 and the coating layer 104 enables that the coating layer 104 may be thinner than without the mesh layer 202. Preferably, the thickness of the coating layer 104 may be similar to the thickness of the substrate 102 if the mesh layer 202 is provided between the substrate 102 and the coating layer 104.

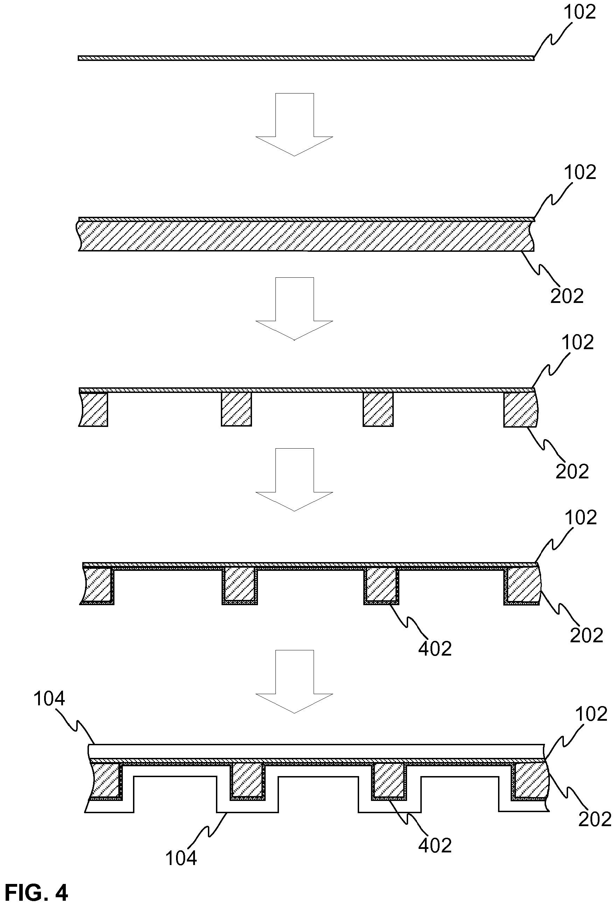

Figure 4 illustrates part of a radiation window manufacturing method according to yet another embodiment of the invention. The first three steps are comparable to corresponding steps in Figure 2 earlier. Thus, the topmost step illustrates a substrate 102 made of silicon nitride. At the second step of Figure 4 a mesh layer 202 is produced on at least on one surface of the substrate 102. In the third step in Figure 4, regularly spaced portions of the originally uniform mesh layer 202 are removed to turn said uniform layer into a mesh. At the next step in Figure 4 a silicon nitride layer 402 is produced on the at least one mesh layer 202. The silicon nitride layer 402 may be manufactured using a thin film deposition technique. Suitable methods for depositing the silicon nitride layer 402 include, but are not limited to, chemical vapour deposition and pulsed laser deposition. Preferably, the silicon nitride layer 402 is between 5 and 500 nanometers thick. The silicon nitride layer 402 on top of the mesh layer 202 may be used to improve at least partly the mechanical strength of the window structure.

At the last step in Figure 4, a coating layer 104 is grown from a vapor phase on outer surface of the combined structure comprising substrate 102, at least one mesh layer 202, and silicon nitride layer 402 as described above. Thus, the silicon nitride layer 402 is provided between the mesh layer 202 on at least one surface of the substrate 102 and the coating layer 104. The last step in Figure 4 is comparable to corresponding last step in Figures 1 and 2 earlier.

The method for manufacturing a radiation window structure described above may be implemented to manufacture a single radiation window structure that may be attached to a support structure. Alternatively, the method may be implemented to manufacture a plurality of radiation window structures on a one wafer. The plurality of the radiation window structures may be cut from the wafer. Furthermore, the plurality of the cut radiation window structures may be attached to corresponding support structures.

Advantages of the invention include the possibility of manufacturing radiation windows where the radiation window foil is very thin and yet gastight, and causes very little unwanted absorption or spurious responses in a measurement involving X-rays. Furthermore, the invention enables manufacturing radiation windows where the mechanical stress caused for example by thermal expansion may be at least partly reduced. Additionally, the pyrolytic carbon used in the coating layer of the radiation window structure is not toxic and it is environmentally sustainable also in the long term.

The specific examples provided in the description given above should not be construed as limiting the applicability and/or the interpretation of the appended claims. Lists and groups of examples provided in the description given above are not exhaustive unless otherwise explicitly stated.

## Claims

1. A method for manufacturing a radiation window structure, the method comprising:
- growing a coating layer (104) from a vapor phase on all outer surfaces of a substrate (102) made of silicon nitride simultaneously.

2. The method according to claim 1, wherein the coating layer (104) grown from the vapor phase is made of pyrolytic carbon.

3. The method according to any of the claims 1 to 2, wherein said growing comprises pyrolysis.

4. The method according to any of claims 1 to 3, wherein the gas used in said growing the coating layer (104) from the vapor phase is methane.

5. The method according to any of claims 1 to 4, comprising producing a mesh layer (202) between the substrate and the coating layer (104) at least on one surface of the substrate (102).

6. The method according to claim 5, comprising producing a silicon nitride layer (402) between the mesh layer (202) on at least one surface of the substrate (102) and the coating layer (104).

## Patentansprüche

1. Verfahren zum Herstellen einer Strahlungsfensterstruktur, wobei das Verfahren Folgendes umfasst:
- gleichzeitiges Züchten einer Beschichtungsschicht (104) aus einer Dampfphase auf allen äußeren Oberflächen eines Substrats (102), das aus Siliziumnitrid hergestellt ist.

2. Verfahren nach Anspruch 1, wobei die aus der Dampfphase gewachsene Beschichtungsschicht (104) aus pyrolytischem Kohlenstoff besteht.

3. Verfahren nach einem der Ansprüche 1 bis 2, wobei das Züchten Pyrolyse umfasst.

4. Verfahren nach einem der Ansprüche 1 bis 3, wobei das beim Züchten der Beschichtungsschicht (104) aus der Dampfphase verwendete Gas Methan ist.

5. Verfahren nach einem der Ansprüche 1 bis 4, umfassend das Herstellen einer Netzschicht (202) zwischen dem Substrat und der Beschichtungsschicht (104) zumindest auf einer Oberfläche des Substrats (102) .

6. Verfahren nach Anspruch 5, umfassend das Herstellen einer Siliziumnitridschicht (402) zwischen der Netzschicht (202) auf mindestens einer Oberfläche des Substrats (102) und der Beschichtungsschicht (104).

## Revendications

1. Procédé de fabrication d'une structure de fenêtre de rayonnement, le procédé comprenant :
- la croissance simultanée d'une couche de revêtement (104) à partir d'une phase vapeur sur toutes les surfaces externes d'un substrat (102) en nitrure de silicium.

2. Procédé selon la revendication 1, dans lequel la couche de revêtement (104) issue de la phase vapeur est en carbone pyrolytique.

3. Procédé selon l'une quelconque des revendications 1 à 2, dans lequel ladite croissance comprend une pyrolyse.

4. Procédé selon l'une quelconque des revendications 1 à 3, dans lequel le gaz utilisé dans ladite croissance de la couche de revêtement (104) à partir de la phase vapeur est du méthane.

5. Procédé selon l'une quelconque des revendications 1 à 4, comprenant la réalisation d'une couche maillée (202) entre le substrat et la couche de revêtement (104) au moins sur une surface du substrat (102).

6. Procédé selon la revendication 5, comprenant la réalisation d'une couche de nitrure de silicium (402) entre la couche maillée (202) sur au moins une surface du substrat (102) et la couche de revêtement (104).
